# EUROPEAN PATENT APPLICATION

(11) **EP 4 577 013 A1**
(43) Date of publication of application: **25.06.2025**
(21) Application number: 23307317.0
(22) Date of filing: 21.12.2023
(51) Int. Cl.: H10K 30/57, H10K 30/85, H10K 30/86, H10K 39/15, H10K 85/50

(54) **PEROVSKITE-SILICON MONOLITHIC TANDEM CELLS WITH MOLECULAR CHARGE RECOMBINATION JUNCTION**

(71) Applicant: Universitat de València, 46010 Valencia (ES); Commissariat à l'Energie Atomique et aux Energies Alternatives, 75015 Paris (FR)
(72) Inventor: BOLINK, Hendrik Jan, 46010 VALENCIA (ES); PALIWAL, Abhyudal Shrikrishan, 46010 VALENCIA (ES); CHOZAS BARRIENTOS, Sofia, 46010 VALENCIA (ES); CARROY, Perrine, 38054 GRENOBLE (FR); MUNOZ, Maria-Delfina, 38054 GRENOBLE (FR)
(74) Representative: Elzaburu S.L.P.

(57) **Abstract**

The present invention refers to a perovskite-silicon monolithic tandem cell comprising a Si-back sub-cell comprising a n-doped hydrogenated amorphous silicon a-Si:H (n) layer as the top layer, a metal halide perovskite front sub-cell and a charge recombination junction (CRJ) that joins the Si-back and perovskite front sub-cells; characterized in that the charge recombination (CRJ) comprises a n-type molecular semiconductor layer comprising a partially reduced electron transporting material (ETM), as the bottom layer of the charge recombination junction (CRJ), and a p-type molecular semiconductor layer comprising a partially oxidized hole transporting material (HTM), wherein the n-type molecular semiconductor layer is in contact with the n-doped hydrogenated amorphous silicon a-Si:H (n) layer of the Si-back sub-cell.

## Description

### FIELD OF THE INVENTION

The present invention refers to a 2T- perovskite-silicon tandem solar comprising an all-molecular semiconductor charge recombination junction (CRJ), which is indium free. Therefore, the invention may be included in the field of multiple junction or tandem solar cells.

### BACKGROUND OF THE INVENTION

Solar cells, herein referred to as photovoltaic (PV) cells, are devices that convert photo-energy from the sun into electrical energy. The dominant technology on the market are silicon-based PV cells, which are reaching their efficiency limit. To further increase the efficiency of Si solar cell a second semiconductor integrated into a second sub-cell is needed. This second sub-cell can either be a semi-transparent cell placed in front of a typical Si-cell or can be integrated onto the unfinished Si cell. The first approach is referred to as a 4-terminal (4T) tandem cell, as it contains 4 electrodes, 2 for each sub-cell. The second approach is referred to as 2-terminal (2T) or monolithic tandem cells. 2T tandem cells have benefits over 4T cells as production costs are less. Perovskite based solar cells have been identified as ideally suited to be used as the front cell in such a 2T tandem cell in which the Si cell is then the back cell (the sunlight goes through the perovskite front cell before it reaches the Si back cell).

Perovskite solar cells also referred to as organic-inorganic (hybrid) lead halide perovskite solar cells have been proposed for photovoltaic applications because of their impressive power conversion efficiencies (PCEs), now exceeding 25%. High quality perovskite films with a high degree of crystallinity are needed in order to reduce the trap concentration and achieve an adequate mobility of the charge carriers. Perovskites, specifically inorganic-organic hybrids, are primarily prepared into thin films via solution-based processes, where precursors or perovskite powders are dissolved in a solution before coating onto a substrate. Coating from solutions has its limitations, primarily due to the need to use coordinating solvents to dissolve the inorganic precursors salts. These solvents, such as dimethylformamide (DMF) or dimethylsulfoxide (DMSO) have a high boiling point which makes it difficult to completely remove them from the finished film. Additionally, these solvents are harmful. For example, DMF has recently been banned for industrial production by the EU. An alternative processing method to prepare perovskite thin films is via vacuum-based processes. These are solvent free processes that are widely used in industrial application. Vacuum processes, such as evaporation, have a proven scalability, being used in many industrial processes from microelectronics, organic PV, and industrial silicon solar cell production lines. On top of this, evaporation is a conformal coating process, able to deposit uniform films on textured surfaces, most relevant when depositing the perovskite on top of the textured silicon surfaces for tandem designs.

Molecular semiconductors are frequently used adjacent to the perovskite semiconductor layer to direct the photo generated charges (electrons and holes) to the respective electrodes of the solar cell. Molecular semiconductors, are also referred to as organic semiconductors, are based on discreet molecules that generally form amorphous films. These materials are used in organic light-emitting diodes and also in small molecular weight organic solar cells. Molecular semiconductors consist of a conjugated region and are capable of transporting holes or electrons. Examples of hole transporting molecules are triphenylamines and bis-triphenylamines (tetra-aryl 4,4'-biphenyldiamines such as N,N'-Bis(naphthalen-2-yl)-N,N'-bis(phenyl)-benzidine (NPB), (N,N,(diphenyl)-N',N'di-(alkylphenyl)-4,4'-biphenyldiamine), tetra-aryl-terphenyl 4,4"-diamines such as N4, N4, N4",N4"-tetra([1,1'-biphenyl]-4-yl)-[1,1':4',1"-terphenyl]-4,4"-diamine (TaTm), tetra-aryl-amine 9,9'-spirobifluorenes, such as 2,2',7,7'-Tetrakis(N,N-di-p-methoxyphenylamino)-9,9'-spirobifluorene (spiro-MeOTAD) and 2,2',7,7'-Tetra(N,N-di-p-tolyl)amino-9,9-spirobifluorene (spiroTTB), carbazoles, 4,4',4-Tris(carbazol-9-yl)triphenylamine (TCTA), diphenylhydrazone, and their derivatives, etc., i.e. molecules able to transport holes, as described for example in the publication "Hole-Transport Materials for Perovskite Solar Cells, Angew.Chem.Int.Ed.2016,55,14522-14545 and in the book: "Organic Photoreceptors for Imaging Systems", appendix 3, by Paul M. Borsenberger and David S. Weiss, Marcel Dekker, Inc, NY 1998., and examples of electron transporting molecules are perylene's, fullerenes, fullerenones, and their derivatives. It is possible to increase the conductivity of molecular semiconductors by a process referred to as doping. In doped molecular semiconductors the conductivity can be varied over several orders of magnitude by increasing the doping concentration. The doping is achieved by partially reducing (n-type doping) the electron transporting material (ETM) and/or partially oxidizing (p-type doping) the hole transporting material (HTM). In the document by Lüssem et al Doped Organic Transistors typical examples of n- and p-type dopants are described. Chem. Rev. vol 116, 13714-13751 (2016), DOI: 10.1021/acs.chemrev.6b00329. In the document by Momblona et al. Efficient vacuum deposited p-i-n and n-i-p perovskite solar cells employing doped charge transport layers, Energy environ. Sci., vol 9, 3456 (2016) n- and p-type doped molecular charge transport layers are described. The document by Forg6cs et al. Efficient Monolithic Perovskite/Perovskite Tandem Solar Cells. Adv. Energy Mater. Vol 7, 1602121 (2017) describes monolithic perovskite/perovskite tandem solar cells fabricated using two perovskite absorbers with complementary bandgaps and employing doped organic semiconductors.

State of the art perovskite-Si 2T tandem cells (Aydin, E. et al. Enhanced optoelectronic coupling for perovskite-silicon tandem solar cells. Nature (2023) doi:10.1038/s41586-023-06667-4.) generally employ inorganic charge recombination junctions (CRJ) between the perovskite and Si sub-cells. The most often employed material for this task is indium tin oxide (ITO) such as in WO2022/096802, which is a metal oxide and consist primarily of indium with small amounts of tin. Indium is a scarce and expensive material. Moreover, ITO can only be deposited using high energy vacuum deposition techniques. Also, the use of ITO based CRJ on textured Si cell complicates the conformal vacuum deposition of the front perovskite sub-cell and provokes very low yields and very low performances in working cells. In conclusion, state of the art 2T perovskite-silicon tandem solar cells may suffer from low yield, low open-circuit voltage, low short-circuit current, low efficiency, short lifetime and/ or low fill factor.

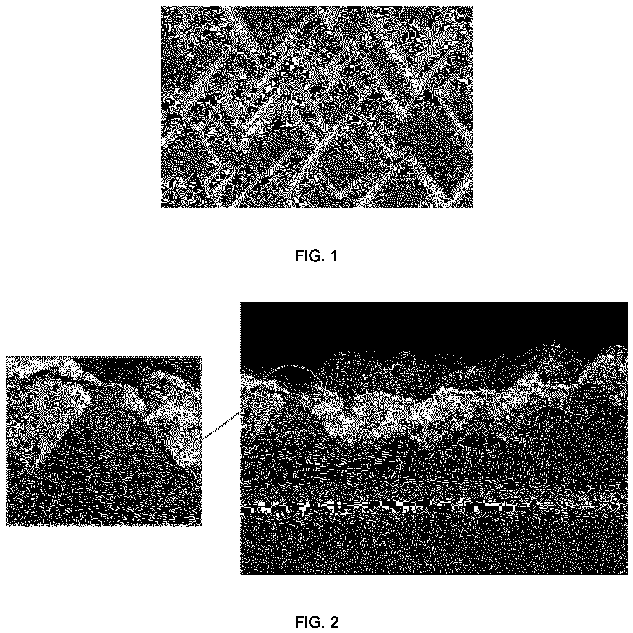

Best performing Si-cell have a textured top surface to facilitate light incoupling which results in a higher current density and thus a higher efficiency. The top of these textured Si substrates appears as pyramids, typically one to a few micrometers in length to the top and at the base (see Figure 1). For this reason, vacuum deposited perovskite front cells hold advantages over solution processed ones as vacuum processed perovskite can cover conformally all the pyramids.

### DESCRIPTION OF THE INVENTION

It is, therefore, the object of the present invention to provide a 2T- perovskite-silicon tandem solar cell which overcomes drawbacks of the prior art. The present invention demonstrates the benefits of using an all-molecular semiconductor charge recombination junction (CRJ). This is an indium free CRJ and can be employed with simple thermal sublimation sources (no high energy plasma methods are required). When in a trial without ITO, a molecular CRJ was deposited, a much better yield and much better performances of working devices were surprisingly observed. There are indications that this may be related to a better adhesion of the front sub-cell to the Si cell.

It is not trivial to identify why the yield and performance of evaporated perovskite on textured Si cell that employ an ITO CRJ do not work very well. This as it requires only one non-covered pyramid to generate mal-functioning tandem cells. As the size of the pyramids is below the optical detection limit only with sub-micrometer analysis tools can these pyramids be visualized. This implies, however, that the area of sight is limited to a few micrometers and hence, complicating the process of identification. Nevertheless, it was found on one SEM image that one of the pyramids was not covered by the perovskite top cell (see Figure 2).

In an attempt to replace the ITO in the CRJ, a double layer of molecular semiconductors was employed. Such junctions have been used in organic solar cells and also by us in perovskite-perovskite tandem cells (in which both sub-cells are based on perovskite absorbers), normally with different bandgaps. These CRJ comprise an electron transporting material (ETM) and a hole transporting material (HTM). To increase the conductivity these materials can be doped. The doping is achieved by partially reducing the electron transporting material (ETM) and by partially oxidizing the hole transporting material (HTM). The ratio of n-type dopant to ETM is in the range of 1:9 to 6:4, more preferable from 3:7 to 5:5. The ratio of p-type dopant to HTM is in the range of 0.5:10 to 3:7, more preferable from 1:10 to 2:8.

Furthermore, in one aspect, a perovskite-silicon monolithic tandem cell comprises a Si-back sub-cell comprising a n-doped hydrogenated amorphous silicon a-Si:H (n) layer as the top layer, a metal halide perovskite front sub-cell and a charge recombination junction (CRJ) that joins these two sub-cells, the Si-back sub-cell and the perovskite front sub-cell. The charge recombination junction (CRJ) further comprises a doped n-type molecular semiconductor layer comprising a partially reduced electron transporting material (ETM), as the bottom layer of the charge recombination junction CRJ, and a doped p-type molecular semiconductor a partially oxidized hole transporting material (HTM). Specifically, the doped n-type molecular semiconductor layer is in contact with the n-doped hydrogenated amorphous silicon a-Si:H (n) layer of the Si-back sub-cell.

This molecular CRJ is deposited on the Si-heterojunction cell containing as final top layer an n-doped hydrogenated amorphous silicon (a-Si:H (n)) layer. As the top layer of the Si cell is a n-type layer the logical thing to do would be to deposit a p-type molecular layer to form an n-p junction (similar to a p-n junction, just grown inverted). However, this does not lead to good solar cells, probably because of the very low conductivity of the a-Si:H layer. Surprisingly, it was found that it is necessary to first place a n-type molecular semiconductor prior to the deposition of the p-type molecular semiconductor. It was also observed that the n-type molecular semiconductor forms a good contact with the n-type a-Si:H layer on top of the Si-back sub-cell.

In general, the molecular CRJ of the invention comprises an electron transporting material (ETM) with the following requirements: it has a LUMO between -3.7 and -4.3 eV below vacuum (as determined by UPS, more preferably between -3.9 and -4.1 eV below vacuum) and a HOMO level below -5.6 eV below vacuum level. Fullerenes are one class of molecules that fulfill these requirements. Examples are C₆₀, C₇₀ and derivates such as PCBM ([6,6]-phenyl-C₆₁-butyric acid methyl ester).

Alternatively, an aromatic compound whose first reduction potential is in the range of about ± 1.0 V, preferably ± 0.5 V, compared to the reduction potential of C₆₀ when measured under the same conditions by cyclic voltammetry against Fc/Fc+ in acetonitrile can be selected as electron transporting material (ETM). Examples of alternative aromatic electron transporting molecules are perylene's, fullerenones, and their derivatives.

Additionally, the electron transporting material (ETM) can be doped with either; a molecular dopant comprising an organic compound having a molecular weight of about 300 to about 1500 g/mol; or a metal dopant selected from the group consisting of a metal halide having a molecular weight of about 25 to about 500 g/mol, or a metal complex having a molecular weight of about 150 to about 1500 g/mol, or a zero-valent metal selected from the group consisting of alkali metal, alkaline earth metal, and rare earth metals. Additionally, the electron transporting material (ETM) can be doped. Examples of n-dopants can be elemental metals, inorganic salts, organic salts, organic hydride molecules and molecular dopants. Examples of elemental metals include Li, Ca, Na, K and Cs. Examples of inorganic salts are X₂CO₃, where X = Li, Na, K, Rb, Cs. Examples of organic salts include pyronin B chloride, crystal violet and pyronine B. Examples of molecular dopants include cobaltocene, decamethylcobaltocene, N1,N4-bis(tri-p-tolylphosphoranylidene) benzene-1,4-diamine (Phlm), tetrakis(hexahydropyrimidinopyrimidine)ditungsten(II) (W₂(hpp)₄) and organic hydride compounds such as leuco crystal violet and derivates of 2,3-dihydro-1H-benzimidazoles (DMBI-H). In a preferable embodiment, DMBI-H, PhIM and W₂(hpp)₄ can be used as n-dopant. In a more preferable embodiment, N1,N4-bis(tri-p-tolylphosphoranylidene) benzene-1,4-diamine (Phlm) is used as p-dopant.

In general, the molecular CRJ of the invention comprises a hole transporting material (HTM) may be selected from the class of triphenylamines, bis-triphenylamines, tetra-aryl 4,4'-biphenyldiamines, such as N,N'-Bis(naphthalen-2-yl)-N,N'-bis(phenyl)-benzidine (NPB) or (N,N,(diphenyl)-N',N'di-(alkylphenyl)-4,4'-biphenyldiamine); tetra-aryl-terphenyl4,4"-diamines, such as N4,N4,N4",N4"-tetra([1,1'-biphenyl]-4-yl)-[1,1':4',1"-terphenyl]-4,4"-diamine (TaTm); poly(tetraphenylbenzidines) (pTPDs); tetra-aryl-amine 9,9'-spirobifluorenes, such as 2,2',7,7'-Tetrakis(N,N-di-p-methoxyphenylamino)-9,9'-spirobifluorene (spiro-MeOTAD) or 2,2',7,7'-Tetra(N,N-di-p-tolyl)amino-9,9-spirobifluorene (spiroTTB); carbazoles, such as 4,4',4-Tris(carbazol-9-yl)triphenylamine (TCTA); diphenylhydrazone, and their derivatives. In a preferable embodiment, tetra-aryl 4,4'-biphenyl di-amines or tetra-aryl-terphenyl4,4"-diamines or tetra-aryl-amine 9,9'-spirobifluorenes can be used as hole transporting material (HTM). In a more preferable embodiment, N4, N4, N4", N4"-tetra([1,1'-biphenyl]-4-yl)-[1,1':4',1"-terphenyl]-4,4"-diamine (TaTm) is used as hole transporting material (HTM).

In a particular embodiment, the first reduction potential of the organic p-type dopant of the doped p-type molecular semiconductor layer of the charge recombination (CRJ) is equal to or more positive compared to 2,3,5,6-Tetrafluor-7,7,8,8-tetracyanochinodimethan (F₄TCNQ) when measured by cyclic voltametry against Fc/Fc+ in acetonitrile at room temperature.

Examples of p-dopants can be metal oxides and small molecules. Examples of metal oxide p-dopants include MoOs, V₂O₅, WO₃. Examples of small molecular p-dopants include F₄-TCNQ and derivatives of F₄-TCNQ including 2-(3-(adamantan-1-yl)propyl)-3,5,6-trifluoro-7,7,8,8-tetracyano-quinodimethane (F₃-TCNQ-Ad1), 3,6-difluoro-2,5,7,7,8,8-hexacyano-quinodimethane (F₂-HCNQ), and 2,2'-(perfluoronaphthalene-2,6-diylidene)dimalononitrile (F₆-TCNNQ) and 2-(7-dicyanomethylene-1,3,4,5,6,8,9,10-octafluoro-7H-pyrene-2-ylidene)-malononitrile, large fluorinated fullerenes such as C₆₀F₃₆ and C₆₀F₄₈, molybdenum tris[1,2-bis(trifluoromethyl)ethane-1,2-dithiolene] (Mo(tfd)₃) and derivatives therefore. In a preferable embodiment, molybdenum tris[1,2-bis(trifluoromethyl)ethane-1,2-dithiolene], 2,2'-(perfluoronaphthalene-2,6-diylidene)dimalononitrile, 2-(7-dicyanomethylene-1,3,4,5,6,8,9,10-octafluoro-7H-pyrene-2-ylidene)-malononitrile] can be used as p-dopant. In a more preferable embodiment, [2,2'-(perfluoronaphthalene-2,6-diylidene)dimalononitrile] is used as p-dopant.

In an specific embodiment, fullerene (C₆₀), or simply C₆₀, is employed as the electron transporting material (ETM) and an arylamine, preferably N4,N4,N4",N4"-tetra([1,1'-biphenyl]-4-yl)-[1,1':4',1"-terphenyl]-4,4"-diamine (TaTm), as hole transporting material (HTM).

In a particular embodiment, to reduce a part of the C₆₀ molecules and increase the conductivity and free carrier concentration, the C₆₀ layer was co-sublimed with an reducing molecule N1,N4-b is(tri-p-tolylphosphoranylidene) benzene-1,4-diamine (Phlm). The hole transporting material (HTM) was partially oxidized using 2,2'-(perfluoronaphthalene-2,6-diylidene)dimalononitrile (F₆TCNNQ).

The Si-back sub-cell is chosen among a Silicon-based cell, e.g., HeteroJunction cell - SHJ -, a Tunnel Oxide Passivated Contact - TOPCon - or a poly-Si on oxide - POLO - cell. According to a possibility, the HeteroJunction Si-back sub cell comprises an absorber layer of c-Si material, a passivation layer of (i) a-Si:H and a n-type doped a-Si:H, nanocristalline, nc-Si:H, or microcrystalline, µc-Si:H, layer at the front side. Another possibility is based on SiOx passivation and a n-type polycrystalline, poly-Si:H, passivation stack.

The back side is based on a P-N junction made by a passivation layer (a-Si:H, SiOₓ, AlOₓ) and a p-type doped contact like: a-Si;H, c-Si, µc-Si:H, poly-Si, nc-Si:H contacted by TCO (ITO, AZO, IO) or a dielectric layer (AlOₓ, SiNₓ, SiOₓ).

The perovskite layer according to this invention comprises at least one perovskite compound. The perovskite compound may have a stoichiometry of AMX₃ or A₂MX₄, where "A" and "M" are cations and "X" is an anion. The "A" and "M" cations can have a variety of charges and in the original Perovskite mineral (CaTiOs), the A cation is divalent, and the M cation is tetravalent. The term "perovskite" as used here refers to the "perovskite crystal structure", but not limited to the specific structure of the perovskite material, CaTiOs. The "Perovskite" may encompass any material that has the same type of crystal structure as calcium titanium oxide, but for the purpose of this invention is limited to materials in which the B cation is bivalent and the A cation monovalent in the ABX₃ structure, and materials in which the bivalent cation is replaced by two separate monovalent cations.

The perovskite formulae as used here may include structures having three or four anions, which may be the same or different, and/or one or two organic cations, and/or metal atoms carrying two or three positive charges. Organic-inorganic perovskites are hybrid materials exhibiting combined properties of organic composites and inorganic crystallinity. The inorganic component forms a framework bound by covalent and ionic interactions, which provide high carrier mobility. The organic component helps in the self-assembly process of those materials. It also enables the hybrid materials to be deposited by low-cost technique as other organic materials.

Additional important property of the organic component is to tailor the electronic properties of the organic-inorganic material by reducing its dimensionality and the electronic coupling between the inorganic sheets.

Additionally, the metal halide perovskite may be a hybrid organic-inorganic perovskite containing at least an organic ammonium halide salt and/or at least one cesium halide salt and/or at least one or more lead halide salt. Preferably, the perovskite is of the structure Fa₁₋ₘ, Csₘ, Pb(I_{3-y}Br_{y}).

In a second aspect, the solution refers to a photovoltaic device comprising the tandem cell previously described.

In a third aspect of the invention, the solution refers to the process to obtain the tandem cell.

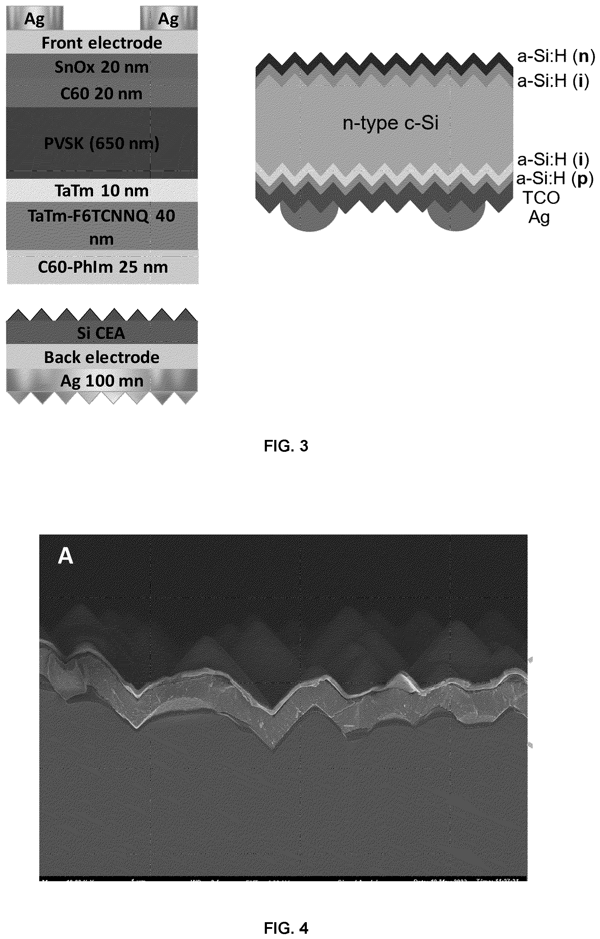

Schematic of the tandem cell with all layers used is shown in Figure 3. In one particular embodiment of the solution, the bottom part of the stack (the Si cell), similar to known heterojunction Si cells, may be deposited on a first indium tin oxide (ITO) electrode or back electrode. The Si-back sub-cell, Si CEA, comprises a n-type top layer but without the final top electrode. That is, the fabrication is interrupted at the stage of the n-type Si layer. The unfinished Si cell is then coated with the following layers, optionally doped, n-type molecular semiconductor (e.g., doped C₆₀), doped p-type molecular semiconductor and intrinsic (not doped) p-type molecular semiconductor, lead halide-based perovskite, intrinsic n-type molecular semiconductor, optionally a n-type inorganic semiconductor (e.g., SnO₂), and a semi-transparent front electrode.

The semi-transparent front electrode can consist of a conductive oxide (TCO) top electrode such as ITO, Al doped ZnOₓ (AZO), In doped ZrOₓ, or similar metal oxides, thin metals or any other semitransparent conducting material. To reduce the resistivity of the semi-transparent front electrode some metallic grid lines are added (Ag).

As result, one embodiment of the tandem cell may comprise:
- a back electrode of indium tin oxide (ITO), optionally containing 100 nm Ag grid lines,
- Si-back sub-cell, deposited on said ITO,
- a charge recombination junction (CRJ)
   - a n-type molecular semiconductor which is 25 nm C₆₀ reduced with Phlm layer, deposited on said Si cell, the weight percent of Phlm is preferably in the range of 30 to 80 %, more preferably between 45 and 60 %.
   - a p-type molecular semiconductor which comprising 40 nm TaTm oxidized with F₆TCNNQ, the weight percent of F₆TCNNQ is preferably in the range of 5 to 30 %, more preferably from 10 to 20 %. And is deposited on said n-type molecular semiconductor, and 10 nm not doped TaTm layer deposited on said doped p-type molecular semiconductor,
   - a lead halide-based perovskite which is 650 nm MAPI deposited on said not doped p-type molecular semiconductor.

Additionally, said tandem cell further comprises a n-type molecular semiconductor which is 20 nm C₆₀ layer deposited on said lead halide-based perovskite, a n-type inorganic semiconductor which is 20 nm SnO₂ layer and a front ITO electrode, optionally containing Ag grid lines, deposited on said n-type inorganic semiconductor.

### BRIEF DESCRIPTION OF FIGURES

Figure 1. Scanning Electron Microscope (SEM) image of the top surface of a textured Si cell.
Figure 2. Scanning Electron Microscope (SEM) image of a Perovskite layer covering a textured Si cell that employes ITO as the CRJ. One of the pyramids poor coverage can be observed (see left panel).
Figure 3. Schematic of the Si-Tandem Cell with molecular CRJ.
Figure 4. Cross section scanning electron microscope (SEM) images of the perovskite-Si 2T tandem cells. A: Shows several pyramids of the Si bottom cell that are fully covered by the CRJ and the perovskite top cell. B: Shows a zoom-in showing the Si pyramides, the CRJ, the perovskite absorber layer, the n-type organic semiconductor layer (ETL) and the top TCO. The organic layers are dark in the image due to lower interaction with the electrons from the SEM.
Figure 5. Current density versus voltage scans of two different 2T tandem cells illuminated with a AM1.5 solar simulator operating at an intensity of 100 mW/cm².
Figure 6. Current density versus voltage scans of two different 2T tandem cells illuminated with a AM1.5 solar simulator operating at an intensity of 100 mW/cm².

### EXAM PLES

### 1. Obtaining the tandem cell of the invention

The tandem cell was constructed by depositing the stack detailed on Figure 3 via vacuum-based deposition techniques directly atop the Si-heterojunction bottom cell. Firstly, the CRJ composed of a 25 nm Phlm-doped C₆₀ (in a ratio of 4:6 Phlm:C₆₀) layer and a 40 nm F₆TCNNQ-doped TaTm (in a ratio of 1:10 F₆TCNNQ:TaTm) layer was deposited via thermal vacuum deposition. Then, using this same technique, a 10 nm layer of intrinsic TaTm was deposited atop the CRJ to reduce the interface recombination induced by the direct contact of the doped TaTm layer with the perovskite. MAPI, which is the metal halide perovskite used in the stack, was deposited via a co-sublimation process forming a 650 nm layer. The setup used for this deposition consists of placing a quartz crystal microbalance (QCM) at the height of the substrate holder where the sum of the co-sublimed precursors, these being PbI₂ and MAI, is read.

This setup allows for a stable and reproducible rate reading regardless of batch-to-batch differences in the precursors. We start by stabilizing the sublimation rate of PbI₂. Once it is stable, the sublimation of MAI was initiated. MAI diffuses into the PbI₂ and the perovskite crystallizes immediately after.

Additionally, a 20 nm layer of C₆₀ is deposited via thermal vacuum deposition to fulfill the role of electron transport layer. Then, a 20 nm SnOₓ buffer layer, used to protect the stack from the ulterior TCO deposition, is placed via atomic layer deposition (ALD). The ITO top electrode is deposited via pulsed laser deposition. Finally, the tandem solar cell was completed by the thermal vacuum deposition of a silver grid which enables the insertion of the charges collected by the ITO electrode into the external circuit.

### 2. Determining the structure of tandem cell of the invention

Film morphology was investigated by using a High Resolution Field Emission Scanning Electron Microscope (HR-FESEM). Images were acquired using an In-Lens Secondary Electron Detector using an accelerating voltage of 1Kv. For the cross-section images, samples were broken with a diamond stylus and glued vertically to the SEM table using double-sided carbon tape. To ensure proper charge dissipation and stable mechanical connection, single-sided cupper tape was also added along the edge of the sample, which was then fixed to the holder with a metallic clip. No extra metallic coating was applied.

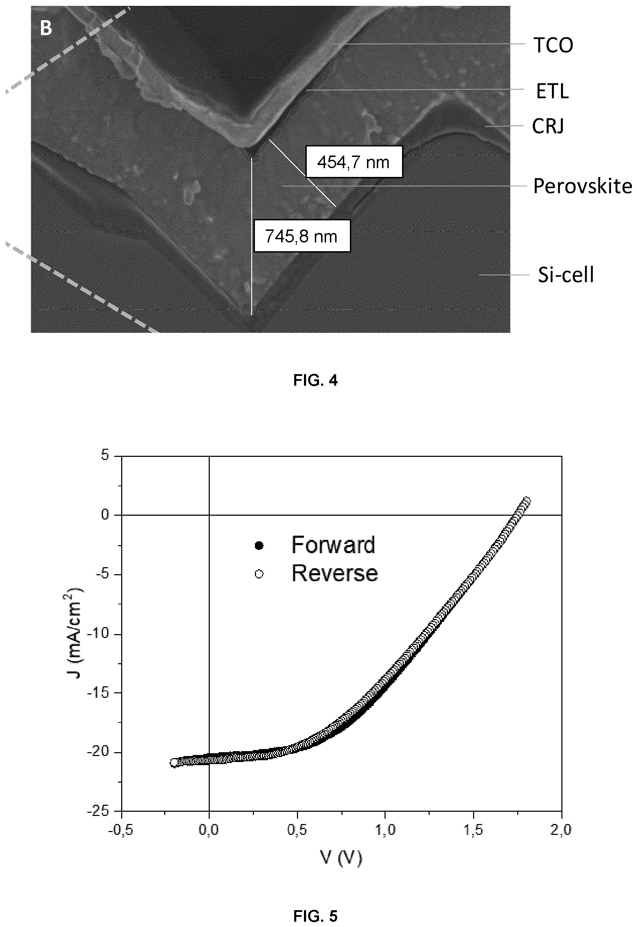

In Figure 4, a cross-section SEM image is shown demonstrating the conformal coating of the molecular CRJ, the perovskite absorber layer, the n-type organic semiconductor layer and the top TCO. Due to differences in interaction with the electrons from the SEM, there is a different color (contrast) between organic and inorganic materials. Due to this we can identify the edge of the Si cell covered by the darker-grey thin film consisting of the CRJ stack. This is followed by a lighter grey film consisting of oval shaped features which is the perovskite layer. After that another dark great layer can be noted which is thinner than the first, which is the n-type organic semiconductor. And it is covered by an inorganic layer, this is both the SnOₓ and the TCO. The contrast between these two layers is small and therefore not noticeable in the image.

### 3. Comparatives with CRJ containing ITO

To evaluate the possible effect of ITO in between the Si and the molecular CRJ, tandem cells with and without an ITO interlayer of 10 nm (all the other layers are as in Figure 3) were evaluated. As can be seen from Figure 5, the power conversion efficiency (PCE) was much worse in the case of the tandem cells in which an ITO layer was present. The current density (J) is similar but the voltage at open circuit (V_{oc}) is much larger for the cell without the ITO layer. The fill factor (FF) which determines at which voltage the maximum power of the cells is obtained is also much larger in the cell without the ITO layer.

Fig 5: red curve is obtained by measuring the tandem cells in which a 10 nm of an ITO interlayer was placed in between the Si cell and the molecular CRJ, Blue curve is obtained by measuring the tandem cells in which the ITO interlayer is not present. Right: Table depicting the key performance parameters of the two types of tandem cells.

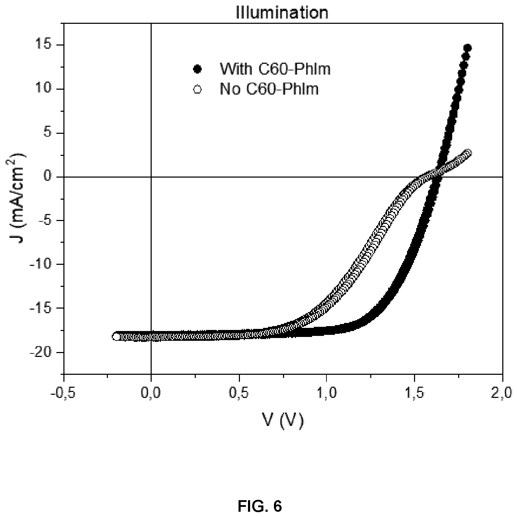

As the top layer of the Si cell is a n-type layer the logical thing to do would be to deposit a p-type molecular semiconductor layer to form an n-p junction (similar to a p-n junction, just grown inverted). We performed this counter experiment by depositing the doped p-type molecular semiconductor layer on the n-type Si layer of the Si-cell (without an ITO interlayer). The results are shown in Figure 6. The J-V curve for the device without the doped n-type molecular semiconductor have an S shape which lead to a poor FF and therefore also to a low PCE. The S-shaped J-V curve is indicative of a charge carrier extraction barrier.

This demonstrates it is necessary to first place a n-type molecular semiconductor prior to the deposition of the p-type molecular semiconductor. The n-type molecular semiconductor forms a good contact with the n-type a-Si:H layer on top of the Si-cell.

Fig 6: Red curve is obtained by measuring the tandem cells in which the doped p-type molecular semiconductor was put directly on top of the Si cell (without the doped n-type molecular semiconductor layer). Blue curve is obtained by measuring the tandem cells as depicted in Figure 2, with the doped-n-type molecular semiconductor in between the Si and the doped-p-type molecular semiconductor. Right: Table depicting the key performance parameters of the two types of tandem cells.

## Claims

1. A perovskite-silicon monolithic tandem cell comprising a Si-back sub-cell comprising a n-doped hydrogenated amorphous silicon a-Si:H (n) layer as the top layer, a metal halide perovskite front sub-cell and a charge recombination junction (CRJ) that joins the Si-back and perovskite front sub-cells,
**characterized in that** the charge recombination (CRJ) comprises:
- a n-type molecular semiconductor layer comprising a partially reduced electron transporting material (ETM), as the bottom layer of the charge recombination junction CRJ, and
- a p-type molecular semiconductor layer comprising a partially oxidized hole transporting material (HTM),
wherein the n-type molecular semiconductor layer is in contact with the n-doped hydrogenated amorphous silicon a-Si:H (n) layer of the Si-back sub-cell.

2. The tandem cell of claim 1, wherein the electron transporting material (ETM) is selected from C₆₀, a derivative of C₆₀, or an aromatic compound whose first reduction potential is in the range of about ± 1.0 V, preferably ± 0.5 V, compared to the reduction potential of C₆₀ when measured under the same conditions by cyclic voltammetry against Fc/Fc+ in acetonitrile.

3. The tandem cell of claim 2, wherein the electro transporting material (ETM) is C₆₀.

4. The tandem cell of any one of previous claims, wherein the electron transporting material (ETM) is doped with either; a molecular dopant comprising an organic compound having a molecular weight of about 300 to about 1500 g/mol; or a metal dopant selected from the group consisting of a metal halide having a molecular weight of about 25 to about 500 g/mol, or a metal complex having a molecular weight of about 150 to about 1500 g/mol, or a zero-valent metal selected from the group consisting of alkali metal, alkaline earth metal, and rare earth metals.

5. The tandem cell of claim 4, wherein the electron transporting material (ETM) is doped using N1,N4-bis(tri-p-tolylphosphoranylidene) benzene-1,4-diamine (Phlm).

6. The tandem cell of any one of previous claims, wherein the first reduction potential of the organic p-type dopant of the doped p-type molecular semiconductor layer of the charge recombination (CRJ) is equal to or more positive compared to 2,3,5,6-Tetrafluor-7,7,8,8-tetracyanochinodimethan (F₄TCNQ) when measured by cyclic voltametry against Fc/Fc+ in acetonitrile at room temperature.

7. The tandem cell of any one of previous claims, wherein the hole transporting material (HTM) is triphenylamines, bis-triphenylamines, (tetra-aryl 4,4'-biphenyldiamines), tetra-aryl terphenyl4,4"-diamines, tetra-aryl-amine 9,9'-spirobifluorenes, carbazoles, diphenylhydrazone, or their derivatives.

8. The tandem cell of claim 7, wherein the hole transporting material (HTM) is N4,N4,N4",N4"-tetra([1,1'-biphenyl]-4-yl)-[1,1':4',1"-terphenyl]-4,4"-diamine (TaTm).

9. The tandem cell of any one of previous claims, wherein the Si-back sub-cell is chosen among HeteroJunction cell - SHJ -, a Tunnel Oxide Passivated Contact - TOPCon - or a poly-Si on oxide - POLO - cell.

10. The tandem cell of any one of previous claims, wherein the metal halide perovskite is a hybrid organic-inorganic perovskite containing at least an organic ammonium halide salt and/or at least one cesium halide salt and/or at least one or more lead halide salt.

11. The tandem cell of the claim 10, wherein the perovskite is of the structure Fa₁₋ₘ, Csₘ, Pb(I_{3-y}Br_{y})

12. The tandem cell of any one the previous claim comprising the following layers:
- a back electrode of indium tin oxide (ITO), optionally containing Ag grid lines,
- Si-back sub cell, deposited on said ITO,
- a charge recombination junction (CRJ)
- a doped n-type molecular semiconductor, which is C₆₀ reduced with Phlm, deposited on said Si cell,
- a doped p-type molecular semiconductor which comprising TaTm oxidized with F₆TCNNQ deposited on said n-type molecular semiconductor, and not doped TaTm deposited on said doped p-type molecular semiconductor,
- a lead halide-based perovskite which is MAPI deposited on said not doped p-type molecular semiconductor.

13. The tandem cell according to claim 12, wherein it further comprises a n-type molecular semiconductor which is C₆₀ deposited on said lead halide-based perovskite, a n-type inorganic semiconductor which is SnO₂ and a front ITO electrode, optionally containing Ag grid lines, deposited on said n-type inorganic semiconductor.

14. A photovoltaic device comprising the tandem cell according to any one of previous claims.

15. A process to obtain a photovoltaic device according to claim 13 comprising the following steps:
- providing a back indium tin oxide (ITO) electrode
- depositing a Si-back sub-cell on said ITO, wherein the Si-back sub-cell comprises a n-doped hydrogenated amorphous silicon (a-Si:H (n)) layer as the top layer,
- depositing a doped n-type molecular semiconductor on said Si cell,
- depositing a doped p-type molecular semiconductor on said n-type molecular semiconductor,
- depositing a not doped p-type molecular semiconductor on said doped p-type molecular semiconductor,
- depositing a lead halide-based perovskite on said not doped p-type molecular semiconductor,
- optionally, depositing a n-type molecular semiconductor which is C₆₀ deposited on said lead halide-based perovskite, depositing a n-type inorganic semiconductor, and depositing a front ITO electrode.
